# EUROPEAN PATENT APPLICATION

(11) **EP 1 571 709 A2**
(43) Date of publication of application: **07.09.2005**
(21) Application number: 05003783.7
(22) Date of filing: 22.02.2005
(51) Int. Cl.: H01L 27/00, H01L 51/20

(54) **Organic electroluminescencent devices**

(30) Priority: 01.03.2004 JP 2004055792
(71) Applicant: International Manufacturing and Engineering Services Co., Ltd., Kanagawa-ken (JP)
(72) Inventor: Nakada, Takeshi, 3,Kirihara-cho Fujisawa-shi Kanagawa-ken (JP)
(74) Representative: Schaumburg, Thoenes, Thurn, Landskron

(57) **Abstract**

An organic electroluminescent device includes at least three electrode layers and organic electroluminescent light-emitting structures, a number of which structures is smaller by one than that of the electrode layers, on a substrate. The electrode layer and the light-emitting structure are alternately formed in this order on the substrate. A group of the electrode layers formed in an odd-numbered layer position from the substrate and a group of the electrode layers formed in an even-numbered layer position from the substrate are electrically connected at a same potential, respectively. Light is alternately emitted in a group of the organic electroluminescent light-emitting structures formed in an odd-numbered layer position from the substrate and a group of the organic electroluminescent light-emitting structures formed in an even-numbered layer position from the substrate, upon application of an alternating voltage between the above-described two groups of the electrodes layers.

## Description

### BACKGROUND OF THE INVENTION

### 1. Field of the Invention

The present invention relates to an organic electroluminescent device (hereinafter, abbreviated as an "organic EL device") comprising two or more organic light-emitting structures which can exhibit light emission upon application of an alternating current.

### 2. Description of the Related Art

Recently, organic semiconductors and organic conductive materials have been actively studied, and particularly, an organic EL device which is a light-emitting element using an organic semiconductor has been remarkably progressed.

In such organic EL devices, Tang et al. have successfully found that high luminance and high efficiency sufficient for practice use of the EL devices such as luminance of 1,000cd/m² and external quantum efficiency of 1% at an applied DC voltage of not more than 10V can be obtained, if a laminate structure of organic compounds having different carrier transporting properties (that is, organic hole-transporting compounds and organic electron-transporting compounds) are applied to the devices so that a balanced injection of holes and electrons from an anode and cathode, respectively, is attained, and also a thickness of the organic layer sandwiched between the cathode and the anode is controlled to not more than 2,000 Angstrom (cf. Tang et al., Appl. Phys. Lett., Vol.51, p913 (1987); Japanese Unexamined Patent Publication (Kokai) Nos. 59-194393, 63-264692 and 2-15595; and US Patents Nos. 4,539,507, 4,769,292 and 4,885,211).

Further, recently, ideas of stacking two or more light emitting units (that correspond to the portion sandwiched between the electrodes in the conventional structure) in series in terms of a circuit to increase an efficiency of the devices have been suggested in many technical articles and patent literatures (cf. Japanese Unexamined Patent Publication (Kokai) No. 11-329748; US Patent No. 6,337,492; Japanese Unexamined Patent Publication (Kokai) No. 2003-264085; and Appl. Phys. Lett., Vol.84, p167 (2004).

In particular, in Japanese Unexamined Patent Publication (Kokai) No. 2003-272860, the applicant of this application and others have invented the method of connecting in series the circuits of two or more organic light-emitting EL units using an electrically insulating charge generation layer having a resistivity (specific resistance) of not less than 10² Ωcm. They have named the resulting device as an MPE (Multi-Photon Emission) organic EL device, and have disclosed and exhibited, with high evaluation, in many conferences, exhibitions and others (cf. 49th lecture meeting, Associate of Society of Applied Physics and others, Preprint 27p-YL-3, p.1308; 63rd lecture meeting, Society of Applied Physics, preprint 27a-ZL-12, p.1165; Proceedings of EL2002 (International Conference on the Science and Technology of Emissive Device and Lighting), p.539; Proceedings of IDMC'03 (International Display Manufacturing Conference), Fr-21-01, p.413; SID03 DIGEST, Vol. XXXIV, BOOKII, p.979; 13th lecture meeting, Production Technology Exhibition of Flat Panel Display, D-4(2003); exhibition and distribution materials concerning white light emissive device by IMES Co., Ltd. at LCD/PDP International 2002, EExpress (Nov. 15, 2002), and Flat Panel Display 2004, strategy section, Part 6-2, p.158 and others).

In this MPE type EL device, the charge generation layer has a structure which is similar to those obtained by laminating, in sequence, the charge (for example, electrons and holes) injection layers being disposed adjacent to the electrodes, which have been improved continually by the present applicant and others. More particularly, the charge generation layer is produced by laminating, in sequence, a layer containing radical anion molecules of an organic electron-accepting (electron-transporting) compound produced upon reduction of the electron-accepting compound with a reducing material (also called as an "electron-donating material" or "Lewis base") such as alkaline metals, for example, those disclosed in Japanese Unexamined Patent Publication (Kokai) Nos. 10-270171 (US Patent No. 6,013,384) and 2001-102175 (US Patent No. 6,589,673) and J. Kido and T. Matsumoto, Appl. Phys. Lett., Vol. 73, p.286 (1998), or a thermal reducing reaction generating layer containing radical anion molecules of an organic electron-accepting compound produced upon thermal reduction reaction by using a method described in detail in Japanese Unexamined Patent Publication (Kokai) Nos. 11-233262 (European Patent No. 0936844B1) and 2000-182774 (US Patent No. 6,396,209 and European Patent No. 1011155B1), and J. Endo, T. Matsumoto and J. Kido, Jpn. J. Appl. Phys., Vol. 41 (2002) pp.L800-L803, and a layer containing radical cation molecules of an organic electron-donating (hole-transporting) compound produced upon oxidation of the electron-donating compound with an oxidizing material (also called as an "electron-accepting material" or "Lewis acid") such as V₂O₅, F₄-TCNQ represented by the following formula: 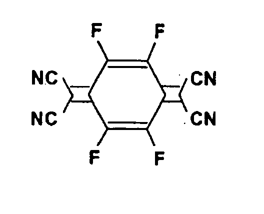 and PNB represented by the following formula: 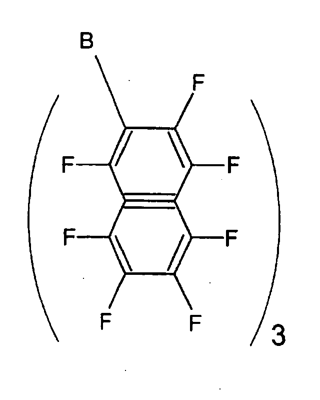 , for example, those disclosed in Japanese Unexamined Patent Publication (Kokai) Nos. 11-251067 (US Patent No. 6,423,429), 2001-244079 (US Patent No. 6,589,673), 2003-272860, Japanese Patent Application No. 2003-358402, and J. Endo, T. Matsumoto and J. Kido, Jpn. J. Appl. Phys., Vol. 41 (2002) L358. Reference literature: K.L.T. Dao and J. Kido, J. Photopolym. sci. Technol., 15, 261(2002).

In the above- mentioned organic EL device structure when the sections (light-emitting units) having been sandwiched between the cathode and the anode in the conventional structure are laminated through the above-described charge generation layer, photons can be produced in the multiple light-emitting units as a result of recombination of the holes and electrons in each unit, because holes generated in the charge generation layer are moved in the direction of the cathode and the electrons are moved in the direction of the anode during application of the voltage. In consequence, it has been proved that when the number of the charge generation layers contained in the EL devices is "n", a light emission intensity per unit of the injected current density (for example, "quantum efficiency" or "current efficiency") can be increased to approximately (n + 1) times.
Apart from the described above, prior to the filing date of the above-cited patent application, the present applicant and others have disclosed the similar structure using ITO (indium tin oxide), widely known as a transparent electrode, as the charge generation layer in Japanese Unexamined Patent Publication (Kokai) No. 2003-045676.

In this instance, as is easily appreciated, ITO used as the charge generation layer can play a role of injecting both of the carriers, i.e., electrons and holes, in the opposed directions, respectively, during application of voltage. But, since the materials suitable for the formation of the anode and the cathode in the organic EL devices were disclosed in Kodak, US Patent No. 4,885,211 cited above, there have been known in common that the suitable cathode material is a metal having a low work function of not more than 4.0eV, while, on the contrary, the material suitable for the formation of the anode electrode is a material having a work function as high as possible such as ITO having a work function of about 5.0eV.

However, it has been found that, even if ITO is used as the cathode electrode, electron injection can be facilitated without formation of an injection barrier, if an electron-donating metal doped layer disclosed by the present applicant and others in Japanese Unexamined Patent Publication (Kokai) Nos. 10-270171 (US Patent No. 6,013,384) and 2001-102175 (US Patent No. 6,589,673) or a thermal reducing reaction generating layer disclosed in Japanese Unexamined Paten Publication (Kokai) Nos. 11-233262 (European Patent No. 0936844B1) and 2000-182774 (US Patent No. 6,396,209 and European Patent No. 1011155B1) is used as an electron injection layer. Accordingly, as a result of formation of both of the anode electrode and the cathode electrode from ITO and because of use of essentially transparent glass substrate and organic layers, it became possible to provide a transparent light emissive device capable of emitting light while ensuring a transparent state as in glass under the non-light emission conditions. The working example of such a transparent light emissive device is disclosed in the example section appended to Japanese Unexamined Patent Publication (Kokai) No. 2002-332567 by the present applicant and others. Moreover, on the contrary, as is disclosed by the present applicant and others in Japanese Unexamined Paten Publication (Kokai) Nos. 11-251067 (US Patent No. 6,423,429), 2001-244079 (US Patent No. 6,589,673) and 2003-272860, and Japanese Patent Application No. 2003-358402, a metal which has a lower work function than that of ITO and thus hitherto has been regarded to be unsuitable as a hole injection electrode such as aluminum (work function of 4.2eV) can be used for the purpose of hole injection without suffering from an injection barrier, if an electron-accepting material is doped in a hole injection layer. The practical example of the device using aluminum as the anode material according to this method is described in, for example, Examples 3 and 4 of Japanese Patent Application No. 2003-358402.

That is, it has been already disclosed that both of holes and electrons can be injected into the EL devices without causing any injection barrier, regardless of the work function of the electrode material and also the optical properties such as transparency or opacity, using the electron injection layers or the hole injection layers disclosed in the above-cited patent literatures.

In the organic EL devices described above, light emission is generally generated by the application of the direct electric current to the devices. Alternatively, it has been also tried to apply the alternating electric current to the EL devices to obtain light emission therein. As described in Kodak, US Patent No. 5,552,678, the merits obtained by driving the organic EL devices with the alternating current include the extended durability of the devices in comparison to that obtained with the direct current driving. However, in the organic EL devices having a rectification function, as a matter of course, the EL devices can be lighted only by biasing the voltage forward, and no light is emitted with the reverse voltage biasing. Accordingly, flickering of the emitted light is sensed to human eyes at the frequency of about 50Hz as in the commercial electric sources.

The present invention is based on these technical backgrounds, and an object of the present invention is to enable driving the organic EL devices which are essentially designed to be driven with a direct electric current, with an alternating electric current, thereby providing a novel structure of the organic EL devices capable of producing continuous light emission without flickering to human eyes.

### SUMMARY OF THE INVENTION

According to an aspect of the present invention, an organic electroluminescent device is provided, at least three electrode layers and organic electroluminescent light-emitting structures, a number of which structures is smaller by one than that of the electrode layers, on a substrate. The electrode layer and the light-emitting structure are alternately formed in this order on the substrate. A group of the electrode layers formed in an odd-numbered layer position from the substrate and a group of the electrode layers formed in an even-numbered layer position from the substrate are electrically connected at a same potential, respectively. Light is alternately emitted in a group of the organic electroluminescent light-emitting structures formed in an odd-numbered layer position from the substrate and a group of the organic electroluminescent light-emitting structures formed in an even-numbered layer position from the substrate, upon application of an alternating alternate voltage between the above-described two groups of the electrodes layers.

It is also desirable for the organic electroluminescent device that the organic electroluminescent light-emitting structure is a laminate of two or more light-emitting units each containing at least one light-emitting layer, the two or more light-emitting units are partitioned with a charge generation layer, and the charge generation layer is an electrically insulating layer having a resistivity of at least 1.0 x 10² Ωcm.

It is desirable for the organic electroluminescent device that the electrode layers each is a transparent electrode layer.

It is desirable for the organic electroluminescent device that any one layer of the electrode layers is an opaque electrode layer.

It is desirable for the organic electroluminescent device that the opaque electrode layer includes a metal layer.

It is desirable for the organic electroluminescent device that the opaque electrode layer includes only one opaque electrode layer, and the opaque electrode layer is formed at the first layer position from the substrate or at a layer position which is farthest away from the substrate.

### BRIEF DESCRIPTION OF THE DRAWINGS

Figure 1 is a cross-sectional view schematically showing the structure of the organic EL device according to one embodiment of the present invention;
Figure 2 is a cross-sectional view schematically showing the structure of the organic EL device according to Example 1 of this application;
Figure 3 is a plan view schematically showing the layout of the first electrode layer on the substrate in the organic EL device according to Example 1 of this application;
Figure 4 is plan views schematically showing the structure of the masking means used in the production of the organic EL device according to Example 1 of this application in which Figure 4A shows an area-controlling mask for the formation of the organic EL light-emitting structures, Figure 4B shows an area-controlling mask for the formation of the even-numbered electrode layers and Figure 4C shows an area-controlling mask for the formation of the odd-numbered electrode layers;
Figure 5 is a plan view schematically showing the structure of the organic EL device according to Example 1 of this application;
Figure 6 is a cross-sectional view of the organic EL device taken along line VI-VI of Figure 5;
Figure 7 is a graph showing the characteristic curve of the DC voltage (V) - current density (mA/cm²) for the first organic EL light-emitting structure and the second organic EL light-emitting structure in the organic EL device according to Example 1 of this application;
Figure 8 is a graph showing the characteristic curve of the DC voltage (V) - luminance (cd/m²) for the first organic EL light-emitting structure and the second organic EL light-emitting structure in the organic EL device according to Example 1 of this application;

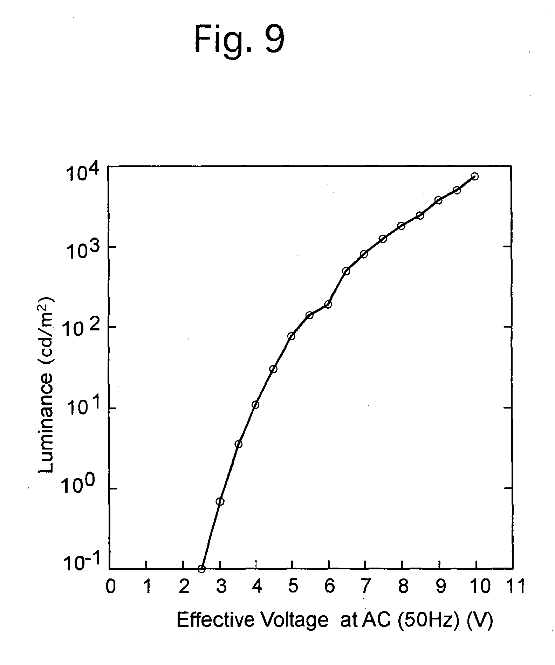

Figure 9 is a graph showing the characteristic curve of the effective voltage (V) at AC of 50Hz - luminance (cd/m²) according to Example 1 of this application;
Figure 10 is a graph showing the light emission spectrum of the organic EL device according to Example 1 of this application; the spectrum from the first organic EL light-emitting structure, the second organic EL light-emitting structure and from the organic EL device when it is driven by alternate voltage.
Figure 11 is a photograph showing the light emission condition of the organic EL device according to Example 1 of this application; and
Figure 12 is a plan view schematically showing the structure of the organic EL device according to Example 1 of this application, corresponding to Figure 11.

### DESCRIPTION OF THE PREFERRED EMBODIMENTS

The present invention will be further described with regard to the preferred embodiments thereof referring to the accompanying drawings. The organic electroluminescent (EL) device according to the embodiment described herein comprises a group of three or more electrode layers, and the EL device comprises a substrate, and electrode layers and organic EL light-emitting structures which were alternately formed on the substrate in the following order:
(1) first electrode layer;
(1') first organic EL light-emitting structure;
(2) second electrode layer;
(2') second organic EL light-emitting structure;
(3) third electrode layer;
(3') third organic EL light-emitting structure;
(4) fourth electrode layer;
(4') fourth organic EL light-emitting structure;

(n-1) (n-1)th electrode layer;
(n-1') (n-1)th organic EL light-emitting structure; and
(n) (n)th electrode layer. Note herein that the layer position number (n) is an integer of at least 3.

Each of the organic EL light-emitting structures has a structure in which holes are injected from the substrate side, and electrons are injected from the side which is far from the substrate. That is, all the organic EL light-emitting structures have the same biasing direction. Accordingly, light emission is made in the organic EL light-emitting structures under the conditions that in the electrode layers sandwiching the light-emitting structure, a positive (+) voltage is applied to the electrode layer appearing on the substrate side and a negative (-) voltage is applied to the electrode layer appearing on the side far from the substrate. No light emission is generated in the structure when the negative (-) voltage is applied to the substrate-sided electrode layer and positive (+) voltage is applied to the electrode layer far from the substrate.

Alternatively, it is also possible to constitute that electrons are injected from the substrate side, and holes are injected from the side far from the substrate. In the EL light-emitting structure of this constitution, the light emission can be attained in accordance with the manner described above. That is, light emission is generated in this light-emitting structure when the same biasing direction is applied to the structure, and when the negative (-) voltage is applied to the substrate-sided electrode layer and positive (+) voltage is applied to the electrode layer far from the substrate. No light emission is generated in the structure when the positive (+) voltage is applied to the substrate-sided electrode layer and negative (-) voltage is applied to the electrode layer far from the substrate.

In the organic EL device of the present invention, a group of the electrode layers in which the electrode layers are formed in an odd-numbered layer position from the substrate, that is, first electrode layer (1), third electrode layer (3) and others, are electrically connected to each other to be in a same potential. Similarly, a group of the electrode layers in which the electrode layers are formed in an even-numbered layer position from the substrate, that is, second electrode layer (2), fourth electrode layer (4) and others, are electrically connected to each other to be in a same potential.

Upon application of an alternating voltage between the above-described two groups of the electrodes layers, light is alternately emitted in a group of the organic EL light-emitting structures formed in an odd-numbered layer position from the substrate, that is, first organic EL light-emitting structure (1'), third organic EL light-emitting structure (3') and others, and a group of the organic EL light-emitting structures formed in an even-numbered layer position from the substrate, that is, second organic EL light-emitting structure (2'), fourth organic EL light-emitting structure (4') and others.

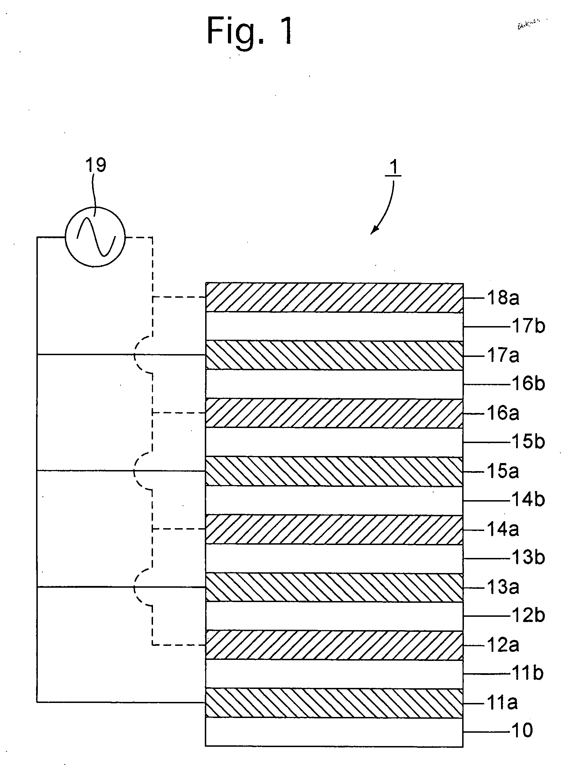

Figure 1 illustrates one example of the organic EL light-emitting device of the present invention in which the layer position number (n) is 8. The organic EL light-emitting device 1 has a substrate 10, and electrode layers and the organic EL light-emitting structures are alternately laminated on the substrate 10 in the following order: first electrode layer 11a, first organic EL light-emitting structure 11b, second electrode layer 12a, second organic EL light-emitting structure 12b, third electrode layer 13a, third organic EL light-emitting structure 13b, fourth electrode layer 14a, fourth organic EL light-emitting structure 14b, fifth electrode layer 15a, fifth organic EL light-emitting structure 15b, sixth electrode layer 16a, sixth organic EL light-emitting structure 16b, seventh electrode layer 17a, seventh organic EL light-emitting structure 17b, and eighth electrode layer 18a.

In the illustrated EL device 1, a group of the electrode layers formed in an odd-numbered layer position from the substrate 10, that is, first electrode layer 11a, third electrode layer 13a, fifth electrode layer 15a and seventh electrode layer 17a are connected to an alternating electric source 19 as shown with the solid line in Figure 1 so that the electrode layers are electrically connected to each other to be in a same potential. Similarly, a group of the electrode layers formed in an even-numbered layer position from the substrate 10, that is, second electrode layer 12a, fourth electrode layer 14a, sixth electrode layer 16a and eighth electrode layer 18a are connected to an alternating electric source 19 as shown with the broken line in Figure 1 so that the electrode layers are electrically connected to each other to be in a same potential.

The organic EL light-emitting structures 11b, 12b, 13b, 14b, 15b, 16b and 17b each is disposed in the EL device 1 in such a manner that hole are injected from a side of the substrate 10, and electrons are injected from the side which is far from the substrate 10 (biasing direction in each organic EL light-emitting structure is identical to each other). Accordingly, light is emitted from the EL light-emitting structures 11b to 17b under the conditions that in the two electrode layers sandwiching the light-emitting structure, a positive (+) voltage is applied to the electrode layer on the side of the substrate 10 and a negative (-) voltage is applied to the electrode layer on the side far from the substrate 10. No light is emitted in the structure when the negative (-) voltage is applied to the electrode layer on the side of the substrate 10 and positive (+) voltage is applied to the electrode layer on the side far from the substrate 10.

When an alternating voltage is applied by an alternating electric source 19 between the group of the electrode layers formed in an odd-numbered layer position from the substrate 10 and the group of the electrode layers formed in an even-numbered layer position from the substrate 10 in the organic EL device 1 having the above-described layer structure, light is alternately emitted from a group of the organic EL light-emitting structures formed in an odd-numbered layer position from the substrate 10 (organic EL light-emitting structures 11b, 13b, 15b and 17b), and from a group of the organic EL light-emitting structures formed in an even-numbered layer position from the substrate 10 (organic EL light-emitting structures 12b, 14b and 16b).

In this organic EL device 1, when all of the electrode layers 11a to 18a are constituted from a transparent electrode and the substrate 10 is transparent as in the glass substrate, since the organic EL light-emitting structures 11b to 17b are also transparent, it becomes possible to obtain light emission in both the side of the substrate 10 or the side of the eighth electrode layer 18a in the EL device 1. Alternatively, when either one of the first electrode layer 11a and the eighth electrode layer 18a is constituted from an opaque electrode (including a light reflection layer consisting of metal) and the second electrode layer 12a to the seventh electrode layer 17a each is constituted from a transparent electrode, light generated in the organic EL light-emitting structures 11b to 17b can be emitted from either one of the side of the substrate 10 and the side of the eighth electrode layer 18a in the EL device 1. The opaque electrode may be any one of the first electrode layer 11a to the eighth electrode layer 18a.

In the practice of the present invention, the organic EL light-emitting structures 11b to 17b may have the typical structures disclosed in, for example, the above-described Kodak patents and other literatures, that is, the structure containing only one organic EL light-emitting unit in which the layer structure is typically "anode/hole-transporting layer/light-emitting layer/electron-transporting layer/cathode", or they may have the so-called MPE (multi-photon emission) type organic EL device structure suggested by the present applicant and described above, that is, a combination of two or more organic EL light-emitting units in which the organic EL light-emitting units (each light-emitting unit comprises typically the layer structure section "hole-transporting layer/light-emitting layer/electron-transporting layer") are laminated in sequence through the insulating (i.e. in floating state) charge generation layer (CGL) so that light is simultaneously emitted in the light-emitting units.

The alternating current-driving type organic EL device according to the present invention can be advantageously used as an illumination light source or in a display device. Especially in the field of the illumination light source, since the commercial electric source used therein is an alternating electric source, it is appreciated that the EL device of the present invention is inevitably preferable to the prior art EL devices because of its structure capable of being driven without using an inverter. However, as the case may be, the frequency applied to the EL devices is suitably modified depending upon the use of the EL devices.

### EXAMPLE

The present invention is further described with reference to the working examples thereof. However, the preset invention should not be restricted to these examples, and any conventional materials used in the production of the prior art organic EL devices may be used in the practice of the present invention.

In the following examples, the formation of the organic compound, metal oxide, metal and ITO transparent electrode as a film or layer was carried out by using a vacuum deposition apparatus commercially available from Vieetech Japan Co., Ltd. or the sputtering apparatus commercially available from FTS Corporation. Further, the control in the deposition rate of the vapor deposition materials and in the thickness of the deposited layers was carried out by using a thickness monitor with a quartz oscillator, "CRTM-8000" of ULVAC Co., attached to the vapor deposition apparatus. Furthermore, to determine an actual layer thickness after the layer formation, a stylus step meter, "P10" of Tencor Co. was used. The characteristics of the devices were evaluated with the source meter "2400" of KEITHLEY Co. and the luminance meter "BM-8" of TOPCON Co. The alternating voltage applied to the EL devices was controlled using a sliding voltage controller (slidac) operated at 50Hz. Moreover, a light emission spectrum of the EL devices was measured using the optical multi-channel analyzer "PMA-11" of Hamamatsu Photonics Co. with the driving at the constant electric current.

### [Example 1]

This example is intended to explain the alternating current-driving organic EL device according to the present invention with reference to the most simplified device structure (number of the electrode layers: n=3) simply illustrating the principle of operation thereof.

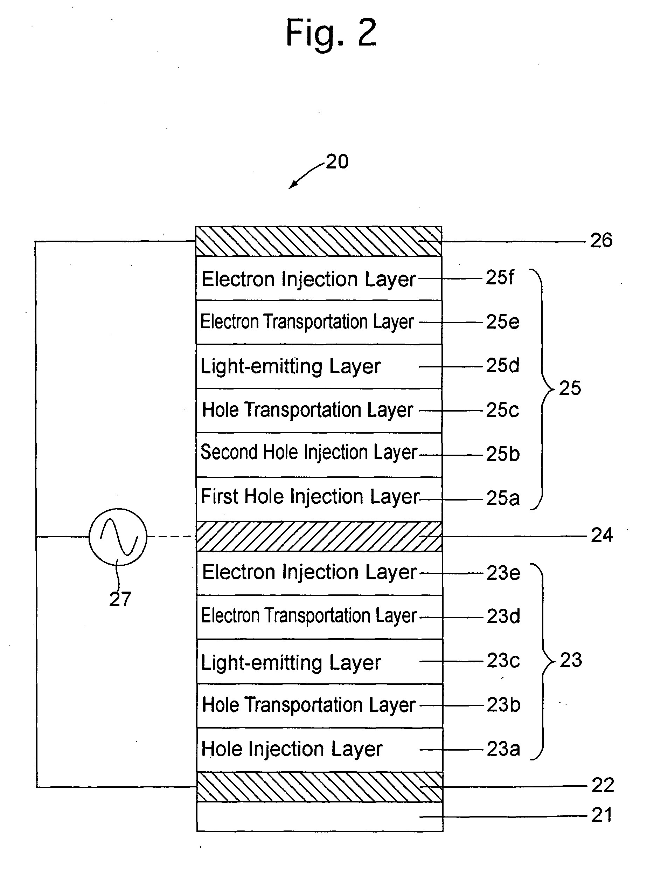

The alternating current-driving organic EL device of this example has the structure illustrated in Figure 2. As is illustrated, the organic EL device 20 comprises a glass substrate 21 and a third electrode layer 26 between which a first electrode layer 22, a first organic EL light-emitting structure 23, a second electrode layer 24 and a second organic EL light-emitting structure 25 are laminated in this order on the substrate 21.

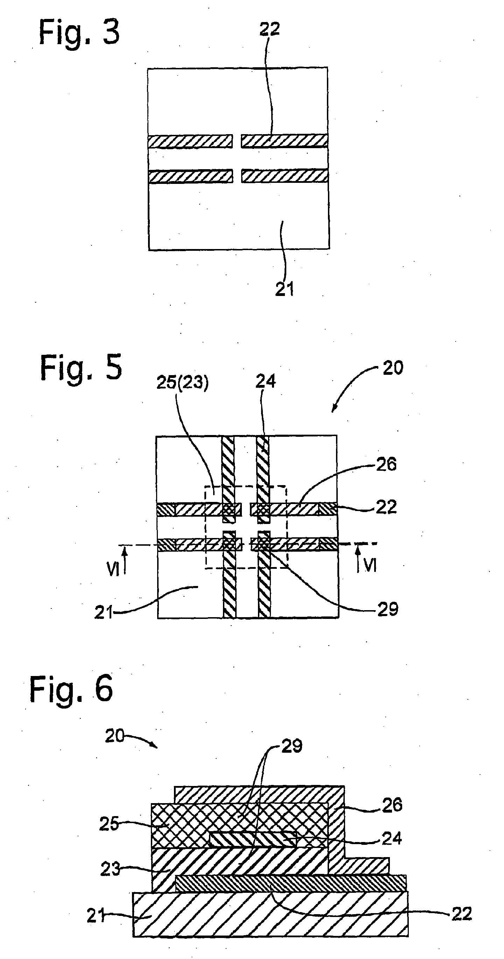

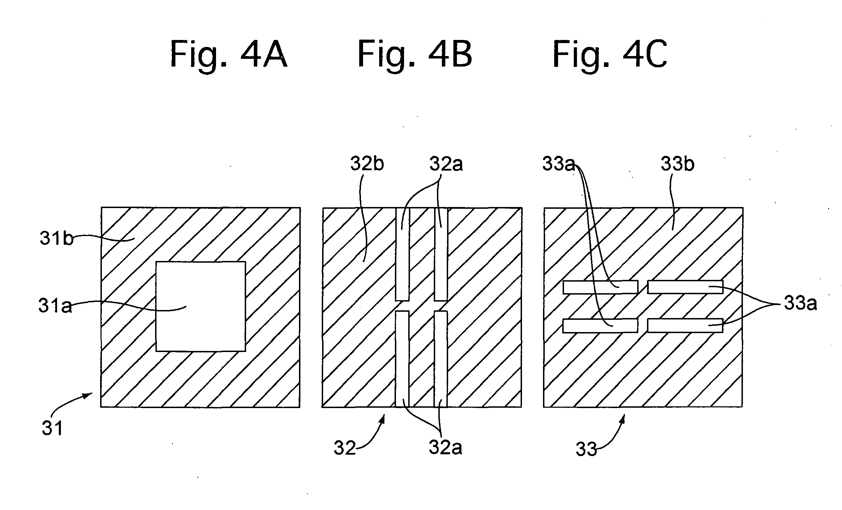

A glass substrate having a size of 3cm x 3cm is prepared. As illustrated in Figure 3, the glass substrate 21 has coated thereon, as a first electrode layer 22, a 2mm width pattern of the ITO (indium-tin oxide; Nippon Sheet Glass Co., Ltd.) having a sheet resistance of about 10 Ω/sq. The substrate 21 is carefully washed with pure water and isopropyl alcohol (IPA), in sequence, followed by dry washing in an UV ozone apparatus ("UV-300", product of SAMCO International Co.). Next, an organic coating for the formation of the first organic EL light-emitting structure 23 shown in Figure 2 is formed using an area-controlling mask 31 for the formation of the organic EL light-emitting structure shown in Figure 4A. The area-controlling mask 31 for the formation of the organic EL light-emitting structure has a rectangular opening section 31a in a central portion thereof, and the peripheral portion surrounding the opening section 31a constitutes a shielding or masking section 31b.

The layers of the first organic EL light-emitting structure 23 are formed in accordance with the following method. First, onto the first electrode layer 22, a layer of an arylamine compound, "HI-406" (unknown molecular structure) commercially available from Idemitsu Kosan Co., Ltd. as a hole injection layer 23a, about 800 Å thick, was deposited.

Next, onto the hole injection layer 23a, a layer of an arylamine compound, "HI-320" (unknown molecular structure) also commercially available from Idemitsu Kosan Co., Ltd. as a hole transporting layer 23b, about 200 Å thick, was deposited.
Thereafter, onto the hole transporting layer 23b, a layer comprising an orange light-emitting material, "RD-001X" (unknown molecular structure) commercially available from Idemitsu Kosan Co., Ltd. and a host material of the light-emitting layer, "BH-140" (unknown molecular structure) also commercially available from Idemitsu Kosan Co., Ltd. as a light-emitting layer 23c, about 500 Å thick, was deposited (i.e. co-deposition of "RD-001X" and "BH-140" in the ratio of 4wt% of "RD-001X").

Next, onto the light-emitting layer 23c, a layer of an aluminum complex of tris(8-quinolinolato) (hereinafter, referred to as "Alq") represented by the following formula: as an electron transporting layer 23d, about 100 Å thick, was deposited. 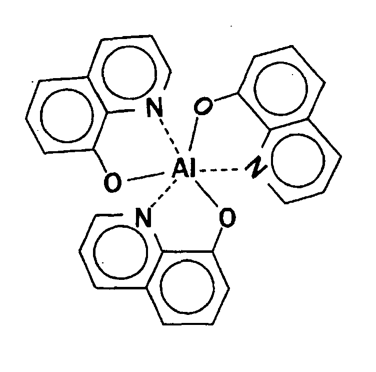 Finally, to form an electron injection layer 23e, i.e., "(in-situ) thermal reducing reaction generating layer" which was disclosed by the present applicant and others in Japanese Unexamined Patent Publication (Kokai) No. 2000-182774 (US Patent No. 6,396,209; European Patent No. 1011155B1), the aluminum complex "Alq" described above and (8-quinolinato) lithium complex (hereinafter, referred to as "Liq") represented by the following formula: 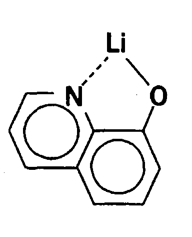 are co-deposited at a molar ratio of 1:1 onto the electron transporting layer 23d. The electron injection layer 23e, about 50 Å thick, is thus obtained. After formation of the co-deposition layer of Alq: Liq as the electron injection layer 23e, a layer of aluminum as a thermal reducing metal at an amount corresponding to the thickness of about 15 Å to form an "in-situ" thermal reducing reaction generating layer (not shown in the Fig.) was deposited. The first organic EL light-emitting structure 23 is thus formed. The structure of the resulting first organic EL light-emitting structure 23 can be simply denoted as follows: HI-406/HT-320/RD-001X:BH-140/Alq/Alq:Liq+Al.

Next, onto the first organic EL light-emitting structure 23, a layer of IZO (indium-zinc oxide) as a the second electrode layer 24, about 1000 Å thick, was deposited in the presence of an area-controlling mask 32 for the formation of the second electrode layer (area-controlling mask for the formation of the even-numbered electrode layers) shown in Figure 4B and in accordance with the sputtering method disclosed by the present applicant and others in Japanese Unexamined Patent Publication (Kokai) No. 2002-332567. As is illustrated, the area-controlling mask 32 for the formation of the second electrode layer has two and parallel long-rectangular opening sections 32a, each of which is extended from the two opposed sides of the mask 32 to end at a central portion thereof. The mask area not constituting the opening sections 32a constitutes a shielding or masking section 32b. Note in the production of the EL devices having 4 or more electrode layers that the area-controlling mask 32 for the formation of the second electrode layer described above is used in the formation of the electrodes in an even-numbered layer position from the substrate.

Over the second electrode layer 24, an organic material film for the formation of the second organic EL light-emitting structure 25 shown in Figure 2 is formed using an area-controlling mask 31 for the formation of the organic EL light-emitting structure shown in Figure 4A.

The layers of the second organic EL light-emitting structure 25 are formed in accordance with the following method. First, a first hole injection layer 25a is formed in the method disclosed by the present applicant and others in Japanese Patent Application No. 2003-358402. That is, a mixed layer of HI-406 and vanadium pentoxide (V₂O₅) is co-deposited at a molar ratio of 1:1 to form the first hole injection layer 25a having a thickness of about 100 Å (Angstrom). The first hole injection layer 25a is introduced in this second organic EL light-emitting structure 25 for the purpose of enabling hole injection from the IZO constituting the second electrode layer 24 to be easy without causing energy barrier (i.e. enabling ohmic contact between the layers).

Next, onto the first hole injection layer 25a, a layer of HI-406 as a second hole injection layer 25b, 1,400 Å thick, was deposited. Further, onto the second hole injection layer 25b, a layer of HT-320 as a hole transporting layer 25c, 200Å thick, was deposited. Furthermore, onto the hole transportation layer 25c, a layer comprising a blue light-emitting material, "BD-102" (unknown molecular structure) commercially available from Idemitsu Kosan Co., Ltd. and a host material of the light-emitting layer, "BH-140" (unknown molecular structure) also commercially available from Idemitsu Kosan Co., Ltd. as a light-emitting layer 25d, about 400 Å thick, was deposited (i.e. co-deposition of "BD-102" and "BH-140" in the ratio of 4wt% of "BD-102"). Next, as in the formation of the first organic EL light-emitting structure 23, Alq is deposited to form an electron transportation layer 25e having a thickness of about 100 Å, and finally Alq and Liq are co-deposited to form a co-deposition layer of Alq:Liq having a thickness of about 50 Å as an electron injection layer 25f.

After formation of the second organic EL light-emitting structure 25, onto the co-deposition layer of Alq:Liq, a layer of aluminum acting as both of a thermal reducing metal and a material for forming a "third electrode layer", 1,000 Å thick, was deposited in the presence of an area-controlling mask 33 for the formation of the third electrode layer (area-controlling mask for the formation of the odd-numbered electrode layers) shown in Figure 4C to simultaneously form a "in-situ" thermal reducing reaction generating layer (not shown in Figures) and the third electrode layer 26. As is illustrated, the area-controlling mask 33 for the formation of the third electrode layer has two pairs of two and parallel long-rectangular opening sections 33a in a central portion thereof. The mask area not constituting the opening sections 33a constitutes a shielding or masking section 33b. Note in the production of the EL devices having 4 or more electrode layers that the area-controlling mask 33 for the formation of the third electrode layer described above is used in the formation of the electrodes in an odd-numbered layer position from the substrate.

As a result of a series of the production process described above, the organic EL device having the structure illustrated in Figure 2 and being simply denoted as follows is thus completed: "ITO/HI-406/HT-320/RD-001X:BH-140/Alq/Alq:Liq+Al/IZO/V₂O₅ :HI-406/HI-406/HT-320/BD-102:BH-140/Alq/Alq:Liq/Al". Note in this structure that the section "V₂O₅ :HI-406/HI-406/HT-320/BD-102:BH-140/Alq/Alq:Liq" corresponds to a second organic EL light-emitting structure 25.

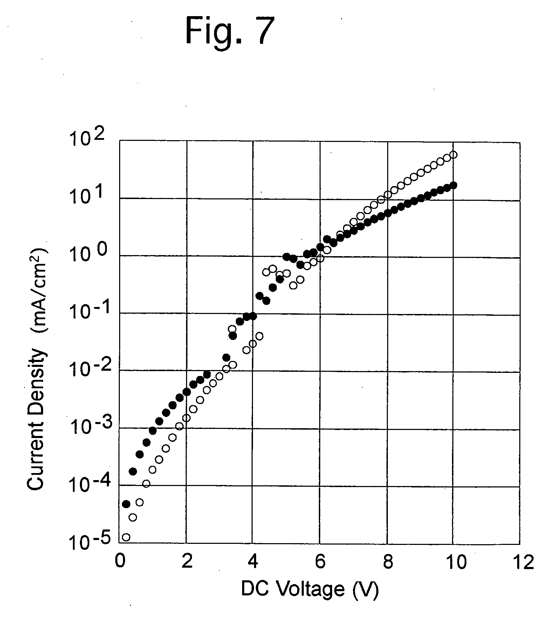

In the resulting organic EL device 20, as shown in Figs. 5 and 6, the third electrode layer 26 and the first electrode layer 22 are formed in the substantially same area when seen from an upper position of the glass substrate 21, and their ends are contacted with each other. Thus, these odd-numbered electrode layers (first electrode layer 22 and third electrode layer 26) are in a same potential. In this EL device 20, light is emitted in each of the section 29 sandwiched by the first electrode layer 22 and the second electrode layer 24 and the section 29 sandwiched by the second electrode layer 24 and the third electrode layer 26.

### [Measurement Examples of Characteristics]

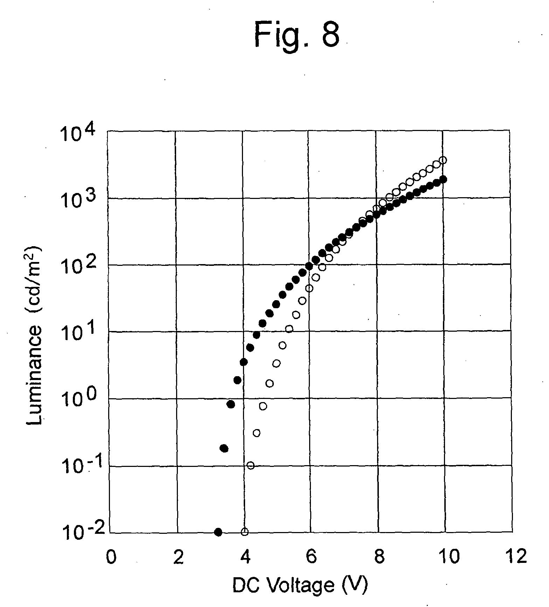

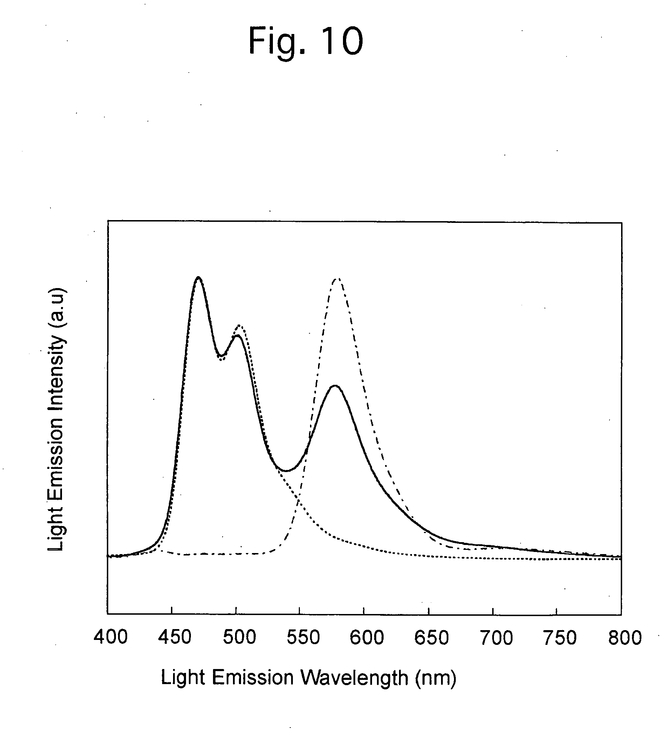

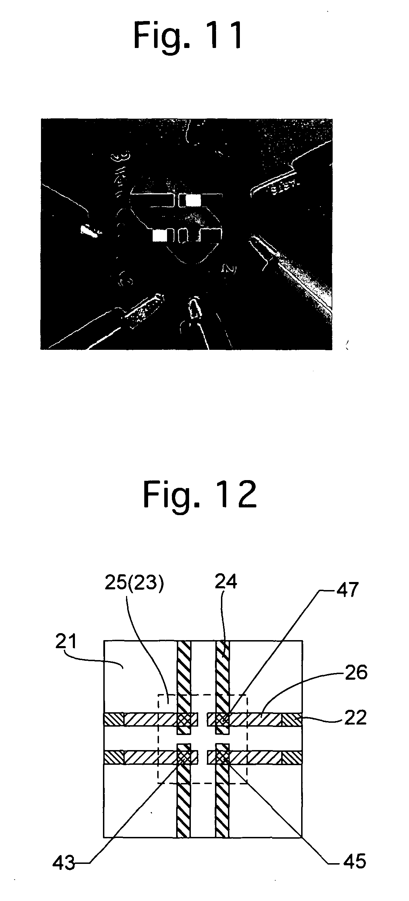

A DC voltage or AC voltage was applied to the organic EL device 20 produced in Example 1, described above, under the below-mentioned measurement conditions to obtain the following results. First, for the purpose of determination of the light emission characteristics in the first organic EL light-emitting structure 23, the first electrode layer 22 and the third electrode layer 26 which are in a same potential to each other as described above were biased to an anode (+) and the second electrode layer 24 was biased to a cathode (-) to apply a DC voltage to the device 20, thereby generating light emission in only the first organic EL light-emitting structure 23. Under this condition, no light was emitted in the second organic EL light-emitting structure 25 because of reverse biasing to this structure. The light emission characteristics of the first organic EL light-emitting structure 23 are plotted with the white circle plots (o) in Figs. 7 and 8. Further, the light emission spectrum in the first organic EL light-emitting structure 23 (at the DC current density of 10 mA/cm² at the voltage of 8.0V) is plotted with the dashed line in Figure 10. Furthermore, the light emission appearance of the first organic EL light-emitting structure 23 is shown in Figs. 11 (photograph) and 12 (see, the light emissive section 43).

Next, for the purpose of determination of the light emission characteristics in the second organic EL light-emitting structure 25, the first electrode layer 22 and the third electrode layer 26 were biased to a cathode (-)and the second electrode layer 24 was biased to an anode (+) to apply a DC voltage to the device 20, thereby generating light emission in only the second organic EL light-emitting structure 25. Under this conditions, no light was emitted in the first organic EL light-emitting structure 23 because of reverse biasing to this structure. The light emission characteristics of the second organic EL light-emitting structure 25 are plotted with the black circle plots (•) in Figs. 7 and 8. Further, the light emission spectrum in the second organic EL light-emitting structure 25 (at the DC current density of 10 mA/cm² at the voltage of 8.3V) is plotted with the broken line in Figure 10. Furthermore, the light emission appearance of the second organic EL light-emitting structure 25 are shown in Figs. 11 and 12 (see, the light emissive section 45).

Thereafter, the measurements were carried out by driving the organic EL device 20 produced in Example 1 under the alternating current conditions, thereby generating alternate light emission in the first organic EL light-emitting structure 23 and the second organic EL light-emitting structure 25. In this measurement example, an AC voltage of 50Hz was applied from the AC electric source 27 between the first electrode layer 22 as well as the third electrode layer 26 which have the same potential to each other and the second electrode layer 24 to determine a luminance per the applied effective voltage. The light emission spectrum, obtained upon application of the AC effective voltage of 10V, in the AC-driven organic EL device is plotted with the solid line in Figure 10. The elapsed time required to measure the light emission spectrum was set to be about 0.2 seconds. Furthermore, the light emission appearance of the EL device are shown in Figs. 11 and 12 (see, the light emissive section 47).

As is appreciated from the light emission spectrum of Figure 10 and the light emission appearance of Figure 11, when the organic EL device is driven with an alternating voltage, a white light is sensed to human eyes, because light is alternately emitted in the first organic EL light-emitting structure 24 capable of emitting an orange light and the second organic EL light-emitting structure 25 capable of emitting a blue light. Accordingly, the organic EL device 20 can emit light continuously and thus without interruption, even if the device is driven with an alternating voltage.

In the above examples, the organic EL light-emitting structures having different emission light colors were used by intention. However, it is of course possible to produce the AC-driving organic EL devices which can satisfy the requirements of the present invention, i.e., prevention of flickering to human eyes and continuous light emission, using the organic EL light-emitting structures each exhibiting the same light emission spectrum.

According to the present invention, since the organic electroluminescent device comprises at least three groups of the electrode layers, and light can be alternately emitted in two or more organic electroluminescent light-emitting structures sandwiched between two groups of the electrode layers, it becomes possible to obtain organic electroluminescent device having no flickering problem observed in the prior art organic electroluminescent devices, and exhibiting an improved durability.

Hereinabove, the present invention was described with regard to the embodiments thereof, but it should be noted that the present invention is not restricted to these embodiments and can be improved or modified for the purpose of improvement or within the scope or spirit of the present invention.

## Claims

1. An organic electroluminescent device comprising at least three electrode layers and organic electroluminescent light-emitting structures, a number of which structures is smaller by one than that of the electrode layers, on a substrate,
the electrode layer and the light-emitting structure are alternately formed in this order on the substrate,
a group of the electrode layers formed in an odd-numbered layer position from the substrate and a group of the electrode layers formed in an even-numbered layer position from the substrate are electrically connected at a same potential, respectively, and
light is alternately emitted in a group of the organic electroluminescent light-emitting structures formed in an odd-numbered layer position from the substrate and a group of the organic electroluminescent light-emitting structures formed in an even-numbered layer position from the substrate, upon application of an alternate voltage between the above-described two groups of the electrodes layers.

2. An organic electroluminescent device according to claim 1, in which said organic electroluminescent light-emitting structure is a laminate of light-emitting units including two or more light-emitting units each containing at least one light-emitting layer, the two or more light-emitting units are partitioned with a charge generation layer, and the charge generation layer is an electrically insulating layer having a resistivity of at least 1.0 x 10² Ωcm.

3. An organic electroluminescent device according to claim 1 or 2, in which said electrode layers each is a transparent electrode layer.

4. An organic electroluminescent device according to claim 1, in which any one layer of said electrode layers is an opaque electrode layer.

5. An organic electroluminescent device according to claim 2, in which any one layer of said electrode layers is an opaque electrode layer.

6. An organic electroluminescent device according to claim 4, in which said opaque electrode layer includes a metal layer.

7. An organic electroluminescent device according to claim 5, in which said opaque electrode layer includes a metal layer.

8. An organic electroluminescent device according to any one of claims 4 to 7, in which said opaque electrode layer includes only one opaque electrode layer, and the opaque electrode layer is formed at the first layer position from the substrate or at a layer position which is farthest away from the substrate.
